# EUROPEAN PATENT APPLICATION

(11) **EP 1 447 840 A1**
(43) Date of publication of application: **18.08.2004**
(21) Application number: 03719140.0
(22) Date of filing: 18.04.2003
(51) Int. Cl.: H01L 21/304, B24B 37/00

(54) **POLISHING PAD AND POLISHING METHOD**

(30) Priority: 26.08.2002 JP 2002244667
(71) Applicant: Nihon Micro Coating Co., Ltd., Akishima-City, Tokyo 196-0021 (JP)
(72) Inventor: OHNO, Hisatomo NIHON MICRO COATING CO., LTD., Akishima-shi, Tokyo 196-0021 (JP); SATO, Satoru NIHON MICRO COATING CO., LTD., Akishima-shi, Tokyo 196-0021 (JP); OSAWA, Kazunari NIHON MICRO COATING CO., LTD., Akishima-shi, Tokyo 196-002 1 (JP)
(74) Representative: Lerwill, John
(86) International application number: PCT/JP2003/005008
(87) International publication number: WO 2004/019395

(57) **Abstract**

A polishing pad for polishing a notch on a circumferential edge portion of a wafer has a disk-shaped center pad of a synthetic resin material and holder plates secured to both surfaces of the center pad so as to expose circumferential portions of the center pad. The circumferential portion of the center pad is sectionally shaped so as to be fittingly insertable into the notch. A foamed resin such as foamed urethane is preferably used as the synthetic resin material. The average diameter of air bubbles in the foamed material is in the range of 10*µ*m - 500*µ*m. The hardness of the foamed material is in the range of 25 - 95 degrees in the Shore hardness A scale. Such a polishing pad is rotated and the circumferential portion of its center pad is fittingly inserted into and pressed against the notch while slurry is supplied to their contact part through a nozzle to polish the notch.

## Description

### Background of the Invention

This invention relates to a polishing pad for and a method of polishing a notch formed on the circumferential edge part of a semiconductor wafer or a semiconductor device wafer (hereinafter simply referred to as "wafer").

Wafers are thin plates intended to serve as the base plate of a semiconductor element, produced by slicing and thereafter polishing an ingot of monocrystalline Si or GaP. In order to indicate the direction of the crystalline alignment, a U-shaped or V-shaped notch is usually provided on its edge. In order to remove the irregularly shaped chipping portions along its edge, a chamfering process is also carried out along the edge.

For forming a semiconductor element on the surface of such a wafer, a film-forming and etching technology such as sputtering, CVD and etching is employed to form an insulating film, an electrode wiring film and a semiconductor film in a layered structure to produce a multi-layered wiring structure.

If the surface quality of the film which serves as the base layer of such a multi-layered structure is not high enough or if its surfaces are not accurately parallel, the quality of the surfaces of the films to be stacked thereon and their parallel relationship cannot be accurate and steps may even be formed in such a situation. Since they are likely to cause short circuits, the surfaces of films are polished whenever they are formed or etched.

Moreover, when the films of a wafer are stacked, extra portions called sags are usually formed around the circumferential areas such as the upper surface, the edge surface and the lower surface of the circumferential edge portion of a wafer. If sags are still left, they are likely to collide with device structures while the wafer is being transported and thereby generate dust particles. Such dust particles are likely to get scattered and float in the air and such floating particles are likely to become attached to the surface of the film, to contaminate the wafer surface and to thereby cause short circuits as explained above. This is why circumferential edge portions of wafers are polished whenever a film is formed.

In order to polish a notch formed on the circumferential edge portion of a wafer, it has been known to insert the edge portion of a disk-shaped polishing pad into the notch on the wafer and to rotate the polishing pad while pressing it and supplying slurry containing dispersed abrading particles to the contact part between the edge portion of the polishing pad and the notch, as disclosed in Japanese Patent Laying-Open No.2000-233354.

According to this prior art technology, however, the disk-shaped polishing pad is made of a woven or non-woven cloth or a fiber material of a woven or non-woven cloth hardened by means of a synthetic resin. As such a polishing pad is used to polish the notch of a wafer, its fibers become fluffy and this can cause many problems. For example, fluffy fibers may break off and generate dust particles which will float in the air, become deposited on the wafer surface and contaminate it; broken fibers may clog the liquid discharge system of the polishing device; the polishing pad will become deformed and will not be able to carry out the polishing work for a long time in a stable manner; and the notch of the wafer may be left with linear scratch marks in the direction of rotation of the polishing pad.

### Summary of the Invention

It is therefore an object of this invention in view of the problems described above to provide a new polishing pad and a new polishing method by means of which a notch on a wafer can be polished stably for a long time without causing dust particles to be generated and without causing scratch marks to be left on the notch.

A polishing pad embodying this invention is disk-shaped and may be characterized not only as comprising a disk-shaped center pad of a synthetic resin material and holder plates secured to both surfaces of the center pad so as to expose circumferential portions of the center pad but also wherein the circumferential portion of the center pad is sectionally so shaped as to be fittingly insertable into the notch. A foamed resin is preferably used as the synthetic resin material and a foamed material is used for the center pad. The average diameter of air bubbles in this foamed material is in the range of 10*µ*m - 500*µ*m. The hardness of the foamed material is in the range of 25 - 95 degrees and more preferably in the range of 40 - 90 degrees in the Shore hardness A scale. Foamed urethane may preferably be used as the foamed material.

For polishing a notch formed on a circumferential edge portion of a wafer, a polishing pad embodying this invention as described above is rotated and a circumferential portion of its center pad is fittingly inserted into the notch and pressed against it. Slurry having abrading particles dispersed therein is supplied to a contact part between the circumferential portion of the center pad and the notch. The wafer may further be tilted while the circumferential portion of the center pad is pressed into the notch to polish the upper surface, the edge surface and the lower surface of the notch.

The invention allows a notch on a wafer to be polished in a stable manner for a long time without generating dust particles and damaging the notch.

### Brief Description of the Drawings

Figs. 1A and 1B are respectively a side view and a front view of a polishing pad embodying this invention, and Figs. 1C and 1D are each a sectional view of its circumferential edge part when inserted fittingly into a notch of a wafer having a different sectional shape.
Fig. 2 is a schematic side view of a polishing device having a polishing pad of this invention mounted thereto.
Fig. 3A is an enlarged photograph of a portion of a polishing pad of Test Example, and Fig. 3B is another enlarged photograph of a portion of a polishing pad of Comparison Example.

### Detailed Description of the Invention

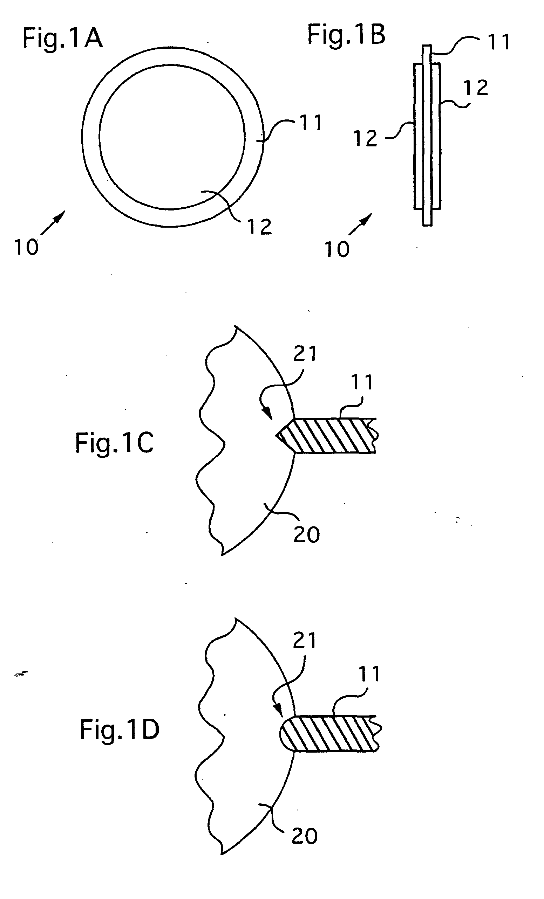

As shown in Figs. 1A and 1B, a polishing pad 10 according to this invention is comprised of a disk-shaped center pad 11 of a synthetic resin material and holder plates 12 affixed to both surfaces of this center pad 11 such that the circumferential edge part of the center pad 11 is exposed.

The sectional shape of the circumferential edge part of the center pad 11 is determined so as to fit inside the notch of the wafer to be polished. In other words, if the notch 21 of the wafer 20 is V-shaped as shown in Fig. 1C, the circumferential edge part of the center pad 11 is also sectionally V-shaped, and if the notch 21 of the wafer 20 is U-shaped as shown in Fig. 1D, the circumferential edge part of the center pad 11 is also sectionally U-shaped.

The polishing pad 10 as shown in Figs. 1A and 1B may be produced by using any prior art molding technology to form a synthetic resin material into the disk-shape of the center pad 11 and then affixing the disk-shaped holder plates 12 with a smaller diameter than the center pad 11 on both surfaces of the center pad 11. The center pad 11 may be molded such that its circumferential edge portion will have a desired sectional shape such as shown in Fig. 1C or 1D. Alternatively, a paring means such as a knife may be used after the center pad 11 has been molded to reform its circumferential edge portion into the desired sectional shape.

Known kinds of synthetic resin such as urethanes and polyesters may be used for the purpose of this invention. Foamed resin materials may appropriately be used as the synthetic resin material for this invention. The center pad 11 may comprise foamed urethane having independent or continuous air bubbles in its interior. The average diameter of such air bubbles may be in the range of 10*µ*m - 500*µ*m such that the abrading particles dispersed in the slurry may be efficiently held therein. The hardness of the foamed material is preferably in the range of 25 - 95 degrees in the Shore hardness A scale and more preferably in the range of 40 - 90 degrees. If the hardness of the center pad 11 is less than 25 degrees, the center pad 11 tends to become deformed during a polishing process and incapable of polishing the notch 21 of the wafer 20 uniformly. If the hardness of the center pad 11 is greater than 95 degrees, excessively large pressure by relatively large ones of the abrading particles in the slurry exerted onto the notch 21 cannot be absorbed and hence the notch 21 may become damaged.

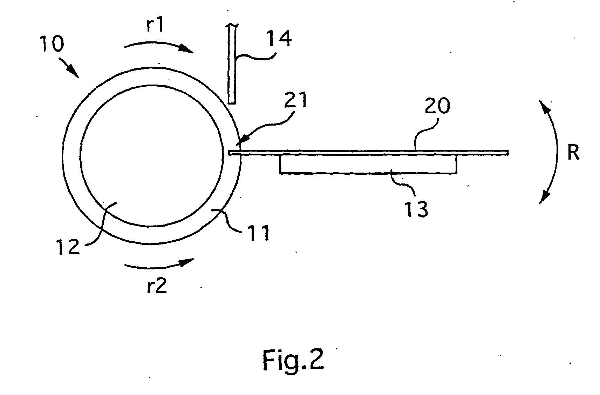

For polishing the notch 21 on the circumferential edge portion of the wafer 20, the wafer 20 is secured first on an affixing table 13, as shown in Fig. 2. An air-suction means (not shown) of a known kind may be used to keep the wafer 20 horizontally on the surface of the table 13 such that the notch 21 is on the side of the polishing pad 10. Next, the polishing pad 10 thus arranged so as to be rotatable in a vertical plane is rotated in the direction of arrow r1 or r2. The polishing pad 10 is connected to a driving means (not shown) of a known kind such as a motor and can be rotated by activating this driving means. Next, a transporting means (not shown) of a known kind such as a ball screw or an air cylinder is used to move the polishing pad 10 or the table 13 so as to be fittingly inserted and press the circumferential edge portion of the center pad 11 of the polishing pad 10 into the notch 21 and slurry having abrading particles dispersed therein is supplied through a nozzle 14 to the contacting part between the circumferential edge portion of the center pad 11 and the notch 21 such that the notch 21 of the wafer 20 is polished. While the circumferential edge portion of the center pad 11 of the polishing pad 10 is kept being pressed into the notch 21, the wafer 20 may be tilted into sloped positions as indicated by double-headed arrow R for polishing the upper surface, the edge surface and the lower surface of the notch 21.

Water or an aqueous solution obtained by mixing a dispersant such as glycols and alcohols to water, having abrading particles dispersed therein, is used as the slurry. The abrading particles may be particles of one or more kinds such as silica, ceria and alumina, having an average diameter of 20nm-200nm. A reaction liquid adapted to react chemically with the sags formed at the notch, containing a substance appropriately selected from potassium hydroxide, sodium hydroxide, ammonium hydroxide, tetramethyl ammonium hydroxide, fluoric acid, fluorides, iron nitrate, potassium iodate, glycine, quinaldinic acid, hydrogen peroxide and benzotriazol, may also be added to the slurry.

The invention is explained next by way of Test and Comparison Examples.

### Test Example

Edge surfaces of a V-shaped notch formed on the circumferential edge portion of a silicon wafer were polished according to this invention. The shape of the notch was that of an equilateral triangle with apex angle of 90° and height 2mm.

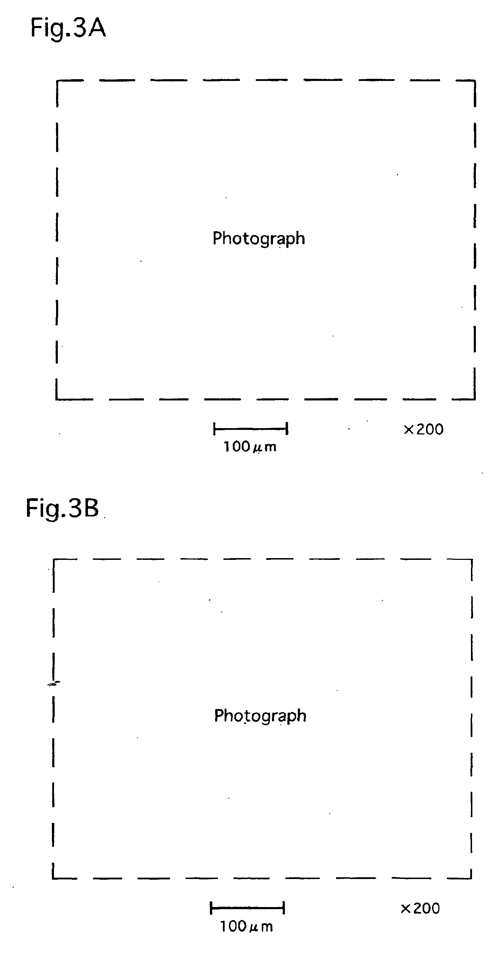

For producing a polishing pad embodying this invention, polyether urethane elastomer (product name Hyprene L-198 manufactured by Mitsui Kagaku Co.) maintained at 80°C and 3,3'-dichloro-4,4'-diamino-diphenylmethane with pure water (1 weight %) added and maintained at 60°C were mixed at weight ratio of 100:19. The mixture thus obtained was poured into a mold having a cylindrically shaped cavity and it was then foamed and hardened (with the temperature of mold = 100°C) for 2 hours. The molded foamed product thus obtained was then removed from the mold and left for 6 days at a room temperature to obtain a foamed body (of foamed urethane) of a cylindrical shape with radius about 200mm. This foamed body was sliced to a thickness of 4mm and its circumferential edge portion was cut in the shape of the notch to produce a disk-shaped foamed urethane pad (radius = 200mm and thickness = 4mm). Holder plates of radius 152mm were affixed to both surfaces of this foamed urethane pad such that its circumferential edge portion would be exposed by 48mm to produce a polishing pad of Text Example. The average diameter of the air bubble in this pad was 200*µ*m and its hardness was 55 degrees in the Shore hardness A scale. Fig. 3A is an enlarged photograph of a portion of the polishing pad of Test Example thus produced.

Polishing of a notched edge surface was carried out four times by varying the speed of rotation of the polishing pad under the conditions shown in Table 1. After each polishing process, the conditions of the polishing pad and the polished notched edge surface were observed. Each polishing process was carried out by rotating the polishing bad in a vertical plane, securing a wafer on a horizontal plane, moving the wafer thus secured towards the polishing pad, fittingly inserting and pressing the circumferential portion of the center pad of the polishing pad into the notch and supplying slurry with abrading particles dispersed therein to the contact part between the circumferential portion of the center pad and the notch.

**Table 1**

| Process No. | 1 | 2 | 3 | 4 |
|---|---|---|---|---|
| Rotational speed of the polishing pad (rpm) | 500 | 600 | 700 | 800 |
| Polishing load (g) | 800 | 800 | 800 | 800 |
| Slurry supply rate (cc/minute) | 50 | 50 | 50 | 50 |
| Polishing time (sec) | 40 | 40 | 40 | 40 |

A colloidal liquid of silica (10 weight %) with average diameter 70nm in water adjusted to pH 10.0 with potassium hydroxide was used as the slurry.

### Comparison Example

A commercially available pad (product name SUBA400 manufactured by RODEL Co.) produced by impregnating a non-woven cloth with urethane resin to thereby harden the fiber structure of non-woven cloth with urethane resin was used as the center pad of the polishing pad of Comparison Example. This center pad was made so as to have the same dimensions (radius = 200mm and thickness = 4mm) as the center pad of the aforementioned Test Example and holder plates were similarly secured to its both surfaces to obtain the polishing pad of Comparison Example. Fig. 3B is an enlarged photograph of a portion of the polishing pad of Comparison Example.

This polishing pad was used to polish the notched edge surfaces of a wafer under the same conditions as in Test Example and the conditions of the polishing pad and the polished notched edge surface were observed.

### Results of Comparison

The results of Test and Comparison Examples were compared. After the polishing, the polishing pad of Comparison Example was found to have its fiber structure broken and fluffy and its circumferential portions deformed. The broken fluffy fibers were also seen to have attached to the surface of the wafer. With the polishing pad embodying this invention, by contrast, there were no fluffs, no deformation of the pad and there was no contamination on the surface of the wafer.

As for the condition of the notched edge surfaces of the wafer after the polishing, linear marks were seen in the direction of rotation of the pad in Comparison Example while no such marks were observed and the notched edge surfaces were mirror-polished in Test Example.

## Claims

1. A disk-shaped pad for polishing a notch formed on a circumferential edge portion of a wafer, said polishing pad comprising:
a disk-shaped center pad of a synthetic resin material; and
holder plates secured to both surfaces of said center pad so as to expose circumferential portions of center pad, said circumferential portion of said center pad being sectionally so shaped as to be fittingly insertable into said notch.

2. The polishing pad of claim 1 wherein said synthetic resin material is a foamed resin and said center pad comprises a foamed material

3. The polishing pad of claim 2 wherein said foamed material has air bubbles with an average diameter of 10*µ*m - 500 *µ*m.

4. The polishing pad of claim 2 wherein said foamed material has hardness in the range of 25 - 95 degrees in the Shore hardness A scale.

5. The polishing pad of claim 2 wherein said foamed material is foamed urethane.

6. A method of polishing a notch formed on a circumferential edge portion of a wafer, said method comprising the steps of:
preparing a polishing pad of any one of claims 1 - 5;
rotating said polishing pad;
inserting said circumferential portion of said center pad fittingly into and pressing said notch; and
supplying slurry having abrading particles dispersed therein to a contact part between said circumferential portion of said center pad and said notch.

7. The method of claim 6 further comprising the step of tilting said wafer while said circumferential portion of said center pad is pressed into said notch.
